# EUROPEAN PATENT APPLICATION

(11) **EP 4 783 782 A1**
(43) Date of publication of application: **29.07.2026**
(21) Application number: 24878808.5
(22) Date of filing: 24.09.2024
(51) Int. Cl.: H10F 71/00, H01L 21/316, H10F 10/166

(54) **TOPCON SOLAR CELL AND PREPARATION METHOD THEREFOR**

(30) Priority: 16.10.2023 CN 202311334473
(71) Applicant: JIANGSU LEADMICRO NANO TECHNOLOGY CO., LTD., Wuxi, Jiangsu 214028 (CN)
(72) Inventor: LIAO, Baochen, Wuxi, Jiangsu 214028 (CN); ZHANG, Xiaojian, Wuxi, Jiangsu 214028 (CN); WANG, Heng, Wuxi, Jiangsu 214028 (CN); YAO, Sen, Wuxi, Jiangsu 214028 (CN)
(74) Representative: De Arpe Tejero, Manuel
(86) International application number: PCT/CN2024/120714
(87) International publication number: WO 2025/082161

(57) **Abstract**

The present application belongs to the technical field of solar cells, and specifically relates to a TOPCon solar cell and a preparation method therefor. In the present application, a tunnel oxide layer is deposited by means of a combination of PECVD and PEALD. A thin oxide layer with a thickness of 0.1-0.5 nm is pre-deposited by means of PECVD, wherein in a subsequent PEALD process, the thin oxide layer chemically passivates a surface of a substrate, and then the PEALD process is used to uniformly deposit a tunnel oxide layer on the basis of the oxide layer. The basic principle of such growth mode is atomic layer deposition, the uniformity of the oxide layer is good, and the influence of an airflow, temperature, electric field and radio frequency in a tube is relatively small; therefore, electroluminescence test defects such as dark spots caused by producing the tunnel oxide layer completely by means of nitrous oxide ionization can be avoided, and the influence of damage of plasma bombardment to the surface of a substrate can be reduced, thereby improving to a certain extent the conversion efficiency of the TOPCon solar cell.

## Description

### CROSS-REFERENCE TO RELATED APPLICATIONS

The present application claims priority to Chinese Patent Application No. 202311334473.0, entitled "TOPCON SOLAR CELL AND PREPARATION METHOD THEREFOR", filed on October 16, 2023, which is herein incorporated by reference in its entirety.

### TECHNICAL FIELD

The present disclosure relates to the technical field of solar cells, and in particular to a TOPCon solar cell and a method for making the TOPCon solar cell.

### BACKGROUND

A high-efficient crystalline silicon solar cell, i.e., a tunnel oxide passivated contact (TOPCon) solar cell, is a new type of silicon solar cell that was proposed by Fraunhofer Institute for Solar Energy Systems in Germany in recent years. The cell utilizes high-quality ultra-thin silicon oxide and doped polycrystalline silicon layer to achieve high-efficient passivation and carrier-selective collection on entire rear surface of the cell.

In a technical field of crystalline silicon solar cell, a TOPCon technology is an excellent cell passivation technology. In the TOPCon cell, a passivated contact layer composed of a tunnel oxide layer and a polycrystalline silicon layer is deposited on the rear surface of the cell. This may allow a metal contact area on the rear surface of the cell to be passivated, and reduce recombination of photogenerated carriers in the metal contact area on the rear surface of the cell, thereby improving cell performance.

In the related art, a plasma enhanced chemical vapor deposition (PECVD) technology is commonly used to prepare the tunnel oxide layer on the rear surface of the TOPCon cell. However, depositing the tunnel oxide layer by directly using nitrous oxide (N₂O) ionization has the following drawbacks. As the tunnel oxide layer continues to grow thicker, an oxygen element needs to pass through already grown oxide layer and enter interior of a substrate (silicon wafer), so that the oxygen element continues to react with silicon. Due to influence of gas flow, a temperature, an electric field, and radio frequency inside a tube during a deposition process, uniformity of PECVD-deposited tunnel oxide layer is relatively poor. Bombardment of plasma on a surface of the substrate causes damage to the surface of the substrate.

In view of this, it is necessary to provide a method for making the TOPCon solar cell that may improve the uniformity of the tunnel oxide layer and avoid damage to the surface of the substrate.

### SUMMARY OF THE DISCLOSURE

The present disclosure provides a TOPCon solar cell and a method for making the TOPCon solar cell, so as to solve technical problems during preparation of the TOPCon solar cell in the related art, such as poor uniformity of a tunnel oxide layer, and damage to a surface of a substrate, etc.

Therefore, the present disclosure provides the following technical solutions.

The present disclosure provides a method for making a TOPCon solar cell including a tunnel oxide layer. A method for making the tunnel oxide layer includes: depositing a first oxide layer on a surface of a substrate by using plasma enhanced chemical vapor deposition, wherein a thickness of the first oxide layer ranges from 0.1 nm to 0.5 nm; and depositing a second oxide layer by using plasma enhanced atomic layer deposition.

The composition of the tunnel oxide layer is not particularly limited in the present disclosure. A material of the tunnel oxide layer is usually silicon dioxide or silicon oxynitride, but silicon oxynitride is not the mainstream choice.

In some embodiments, the thickness of the first oxide layer ranges from 0.1 nm to 0.2 nm.

In some embodiments, a thickness of the second oxide layer ranges from 0.3 nm to 2 nm.

In some embodiments, the method for making the TOPCon solar cell includes:
S1, texturing, performing diffusion on, and alkaline polishing the substrate;
S2, depositing the tunnel oxide layer;
S3, depositing an intrinsic amorphous silicon layer;
S4, depositing a doped amorphous silicon layer;
S5, depositing a silicon dioxide layer; and
S6, annealing, wet cleaning, depositing an atomic layer, coating, printing a front electrode and a rear electrode, and sintering.

The operations S2 to S5 are all performed on a rear surface of the substrate. The operation S1 is texturing the entire substrate, diffusion is performed on the front surface, and alkaline polishing is generally only applied to the rear surface. In the present disclosure, the specific operations of texturing, diffusion, alkaline polishing, wet cleaning, depositing the atomic layer, coating, printing the front electrode and the rear electrode, or the like; as well as operation parameters of the operations S2 to S5 are all conventional in this field, which are not specifically limited here.

In some embodiments, the intrinsic amorphous silicon layer is deposited by using the plasma enhanced chemical vapor deposition in S3. And/or, a thickness of the intrinsic amorphous silicon layer ranges from 10 nm to 20 nm.

In some embodiments, the doped amorphous silicon layer is deposited by using the plasma enhanced chemical vapor deposition in S4. And/or, a thickness of the doped amorphous silicon layer ranges from 20 nm to 130 nm. And/or, the doped amorphous silicon layer includes a phosphorus doped amorphous silicon layer.

In some embodiments, the silicon dioxide layer is deposited by using the plasma enhanced chemical vapor deposition in S5. And/or, a thickness of the silicon dioxide layer ranges from 10 nm to 15 nm.

In some embodiments, in S1, the texturing the substrate includes texturing the substrate through alkali corrosion to form a textured surface. And/or, the performing diffusion on the substrate includes doping a boron element on a front surface of the substrate. And/or, the alkaline polishing the substrate includes alkaline polishing a rear surface of the substrate to form a polished surface.

In some embodiments, in S6, the wet cleaning includes removing a doped amorphous silicon layer at an edge of the substrate and removing a phosphor-silicate glass layer on a rear surface of the substrate. And/or, the depositing the atomic layer includes depositing an aluminum oxide passivation layer on a front surface of the substrate. And/or, the coating includes depositing a silicon nitride anti-reflection layer on each of the front surface and the rear surface of the substrate. And/or, a sintering temperature ranges from 650 °C to 850 °C, and sintering time ranges from 1 min to 2 min.

The present disclosure further provides a TOPCon solar cell prepared by the above-mentioned method of any one of embodiments.

The operation parameters used in the preparation process of each functional layer in the present disclosure are conventional in this field. Typically, without limitation, the operation parameters for depositing the first oxide layer may include: a flow rate of nitrous oxide of 8000 sccm to 10000 sccm, power of 8000 watts to 10000 watts, and deposition time of 15 seconds to 30 seconds.

The operation parameters for depositing the second oxide layer may include: a total flow rate of argon carrying silicon source of 2000 sccm to 2500 sccm, the flow rate of the nitrous oxide of 2000 sccm to 2500 sccm, the deposition time of 1 min to 2 min, and the power of 6000 watts to 9000 watts.

The deposition of the intrinsic amorphous silicon layer is carried out by introducing a mixed gas of the argon and silane, with radio frequency power of 8000 watts to 11000 watts, a deposition temperature of 400 °C to 450 °C, a process pressure of 300 Pa to 360 Pa, the deposition time of 4 min to 8 min, a flow rate of the argon of 6000 sccm to 8000 sccm, a flow rate of the silane of 2000 sccm to 2500 sccm, and a film thickness controlled to be 10 nm to 20 nm.

The deposition of the doped amorphous silicon layer is carried out by introducing a mixed gas of the argon, the silane, and phosphine, with the RF power of 8000 watts to 10000 watts, the deposition temperature of 400 °C to 450 °C, the process pressure of 300 Pa to 360 Pa, the deposition time of 20 min to 30 min, the flow rate of the argon of 6000 sccm to 8000 sccm, the flow rate of the silane of 1500 sccm to 2000 sccm, a flow rate of the phosphine of 2500 sccm to 3000 sccm, and the film thickness controlled to be 20 nm to 130 nm.

The deposition of the silicon dioxide layer is carried out by introducing a mixed gas of the silane and the nitrous oxide, with the RF power of 8000 watts to 10000 watts, the deposition temperature of 400 °C to 450 °C, the process pressure of 200 Pa to 240 Pa, the deposition time of 1 min to 2 min, the flow rate of the silane of 2500 sccm to 3000 sccm, the flow rate of the nitrous oxide of 6000 sccm to 8000 sccm, and the film thickness controlled to be 10 nm to 15 nm.

The technical solutions of the present disclosure have the following advantages.

In the method for making the TOPCon solar cell in the present disclosure, the method, in which the tunnel oxide layer is prepared by using nitrous oxide ionization alone, is changed. In the present disclosure, plasma enhanced chemical vapor deposition (PECVD) and plasma enhanced atomic layer deposition (PEALD) are used in combination for preparing the tunnel oxide layer. In the subsequent PEALD process, the grown first oxide layer plays a chemical passivation role on the surface of the substrate, and then the second oxide layer is uniformly deposited by using PEALD on the basis of the oxide layer. The basic principle of this growth method is atomic layer deposition, with good uniformity of the oxide layer. It is less affected by airflow, a temperature, an electric field, and radio frequency inside a tube. This can avoid the electroluminescence (EL) test defect, such as a dark spot, that occurs when the tunnel oxide layer is formed by using the nitrous oxide ionization alone. This also reduces the damage to the surface of the substrate caused by the plasma bombardment, thereby improving the conversion efficiency of the TOPCon solar cell to a certain extent.

### BRIEF DESCRIPTION OF THE DRAWINGS

The specific implementation scheme of the present disclosure, which is described in detail below, may be best understood in conjunction with the following accompanying drawings.

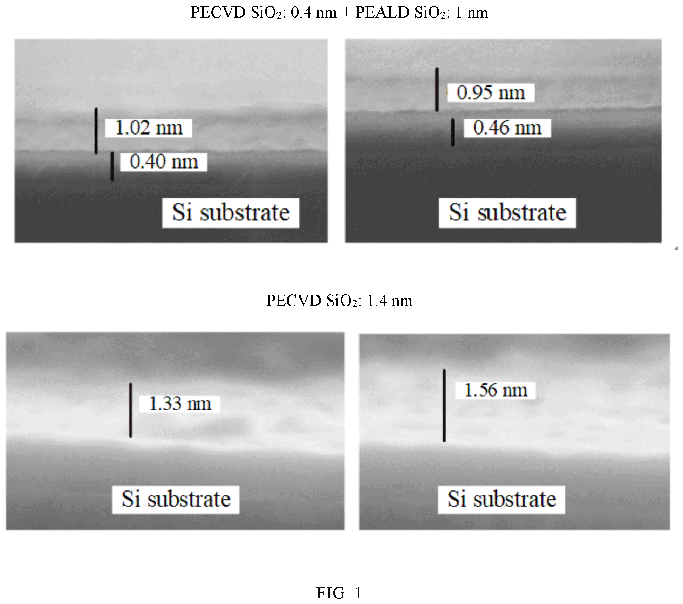

FIG. 1 shows a cross-section of a tunnel oxide layer observed by using a scanning electron microscope (SEM) and shows data for calculating uniformity.

### DETAILED DESCRIPTION

The following embodiments are provided to facilitate a better and further understanding of the present disclosure, and are not limited to the best embodiment described. They do not limit content and protection scope of the present disclosure. Any product that is identical or similar to the present application, whether derived by any person from the inspiration of the present disclosure or obtained by combining features of the present disclosure with features of other prior art, shall fall within the protection scope of the present disclosure.

For those experimental operations or conditions not specifically indicated in the examples, they may be carried out according to conventional experimental operations or conditions described in the literature within the art. For reagents or instruments not indicated with specific manufacturers, they are all conventional reagent products available through commercial purchase.

In a PECVD technology, an externally applied electric field acts on gas involved in the reaction, causing gas ionization, thereby producing a glow discharge effect. In the present disclosure, the radio frequency is employed to achieve nitrous oxide glow discharge, forming plasma. The high-energy plasma undergoes a chemical reaction with the silicon substrate, generating a required oxide layer.

A plasma enhanced atomic layer deposition (PEALD) technology introduces a plasma source on the basis of traditional atomic layer deposition (ALD). In some embodiments of the present disclosure, an oxygen source such as nitrous oxide or oxygen (taking the nitrous oxide as an example) is used as the plasma source. Under activation of the plasma, the nitrous oxide reacts with alternately introduced silicon sources to generate the oxide layer. An oxygen element of the oxide layer comes from ionization of the introduced nitrous oxide, and a silicon element of the oxide layer comes from a silicon source.

In some embodiments of the present disclosure, in a first oxide layer deposited by using PECVD, the oxygen element comes from the ionization of the introduced nitrous oxide, and the silicon element comes from the silicon substrate. Through the surface silicon-based oxidation scheme, the oxide layer grows inward. The formed first oxide layer may planarize the surface of the silicon substrate, while simultaneously serving a surface cleaning function. Moreover, the internal defect recombination is passivated. Therefore, a high-quality c-Si/SiOx interface may be formed.

However, continuing to deposit the tunnel oxide layer (i.e., a second oxide layer) by directly using a PECVD nitrous oxide ionization method has the following drawbacks. The growth of the oxide layer is severely affected by a surface state, and due to gradual thickening of the accumulated oxide layer, the oxygen element needs to pass through the already grown silicon oxide layer and enter the interior of the substrate to continue reacting with the silicon of the substrate. The formed oxide layer blocks diffusion of an oxygen radical toward the silicon substrate, causing growth rate to gradually decrease until saturation, and a thickness of the oxide layer cannot be precisely controlled. This is the biggest drawback of preparing the oxide layer by using PECVD. Furthermore, due to the influence of the gas flow, the temperature, the electric field, and the radio frequency inside the tube during the deposition process, the uniformity of the PECVD-deposited tunnel oxide layer is relatively poor, which cannot achieve the technical effect of good uniformity in the present disclosure. In this case, the tunnel oxide layer SiO₂ is prone to problems such as poor within-wafer uniformity, large batch-to-batch variations, and poor passivation effect in practical applications. In addition, the bombardment of the plasma on the surface of the substrate causes damage to the surface of the substrate.

In some embodiments of the present disclosure, the second oxide layer is formed by using a PEALD technology. In the second oxide layer grown by using the PEALD technology, the oxygen element comes from the ionization of the introduced nitrous oxide, and the silicon element comes from the silicon source. In a PEALD reaction process, the plasma is formed by ionization only when the nitrous oxide is introduced, and no ionization occurs when the silicon source is introduced, thereby reducing the damage to the surface of the substrate caused by the plasma. In addition, the PEALD technology retains a self-limiting reaction characteristic of the ALD and enables deposition layer by layer at the atomic layer level, which provides excellent thickness control and uniformity, solving the requirement for atomic-scale thickness precision control needed for tunneling in the tunnel oxide layer.

However, when PEALD is used to prepare the first oxide layer, the principle of PEALD involves ionizing the nitrous oxide to generate an oxygen negative ion, and the oxygen negative ion reacts with the silicon that comes from the introduced silicon source and that is chemically adsorbed on the surface of the substrate to generate silicon oxide. This process does not consume the silicon from the silicon substrate itself (such as, the silicon from silicon substrate surface itself), resulting in many interface defects and lacking the process of converting defect-state silicon into a silicon oxide layer. Consequently, it cannot achieve the passivation effect of an inner side formed by using PECVD. Moreover, since no silicon from the silicon substrate surface itself is consumed, it also fails to achieve the effect that the silicon substrate surface is planarized on the inner side formed by using PECVD. The quality and the uniformity of the generated silicon oxide layer formed by using PEALD are both inferior to those of the inner side formed by using PECVD. Taking a comparative example 3 described below in the present disclosure as an example, during formation of the tunnel oxide layer, since only the second oxide layer with a thickness of 0.9 nm is grown by using PEALD, without the first oxide layer with a thickness of 0.1 nm grown by using PECVD, overall uniformity of the tunnel oxide layer directly deteriorates. A main reason is that a surface rough layer does not undergo inward epitaxial oxide layer growth, resulting in a rough and uneven interface. This directly led to poor atomic saturation coverage state, unstable periodic growth rate, and island growth during the subsequent atomic layer oxide growth by using PEALD, ultimately causing poor uniformity. That is, in practice, film thickness uniformity depends on a state of an initial interface, such as surface roughness of the substrate.

In addition, when the first oxide layer is prepared by using PEALD and the second oxide layer is prepared by using PECVD, due to a blocking effect of the first oxide layer, when the second oxide layer is prepared by using PECVD, the oxygen radical cannot diffuse to the surface of the silicon substrate, growth of SiO₂ is extremely difficult. This is also unable to achieve the technical effect of the present disclosure. When the oxide layer prepared by using PECVD is not located on the inner side but on an outer side, that is, when PECVD is used to prepare the second oxide layer instead of the first oxide layer, as described in the background of the present disclosure, the deposition of the tunnel oxide layer by directly using the nitrous oxide ionization method in the PECVD technology has the following drawbacks. Due to the influence of the gas flow, the temperature, the electric field, and the radio frequency inside the tube during the deposition process, the uniformity of the PECVD-deposited tunnel oxide layer is relatively poor, which cannot achieve the technical effect of good uniformity in the present disclosure. Similarly, when the silicon oxide layer prepared by using PEALD is not located on the outer side but on the inner side, the principle of PEALD involves ionizing the oxygen source such as the nitrous oxide or the oxygen to generate the oxygen negative ion, and the oxygen negative ion reacts with the silicon that comes from the introduced silicon source and that is chemically adsorbed on the surface of the substrate to generate the silicon oxide. This process does not consume the silicon from silicon substrate surface itself, resulting in lacking the process of converting the defect-state silicon into the silicon oxide layer. Consequently, it cannot achieve the passivation effect of the inner side formed by using PECVD. Moreover, since no silicon from the silicon substrate surface itself is consumed, it also fails to achieve the effect that the silicon substrate surface is planarized on the inner side formed by using PECVD. The quality and the uniformity of the generated silicon oxide layer are both inferior to those of the inner side formed by using PECVD.

### Example 1

This example provides a method for making a TOPCon solar cell, including the following operations.

In an operation 1, the method may include conventional texturing, performing diffusion on, and alkaline polishing an N-type substrate (silicon wafer) with dimensions of 182 mm × 182 mm.

In an operation 2, the method may include depositing the first oxide layer on an alkaline-polished substrate by using the nitrous oxide ionization. During deposition of the first oxide layer, a flow rate of the nitrous oxide is 10000 sccm, power is 8000 watts, deposition time is 15 seconds, and a thickness is controlled to be 0.1 nm. On the basis of the first oxide layer, the second oxide layer is deposited by using PEALD. During deposition of the second oxide layer, a total flow rate of argon carrying the silicon source is 2000 sccm, the flow rate of the nitrous oxide is 2400 sccm, the deposition time is 90 seconds, the power is 9000 watts, and the thickness is controlled to be 1 nm.

In an operation 3, the method may include depositing intrinsic amorphous silicon thin film by using PECVD. A mixed gas of argon and silane is introduced, a radio frequency power is 11000 watts, a deposition temperature is 420 °C, a process pressure is 300 Pa, the deposition time is 6 min, a flow rate of argon is 6000 sccm, a flow rate of the silane is 2500 sccm, and a film thickness is controlled to be 20 nm.

In an operation 4, the method may include depositing a doped amorphous silicon thin film by using PECVD. A mixed gas of the argon, the silane, and phosphine is introduced, the radio frequency power is 10000 watts, the deposition temperature is 420 °C, the process pressure is 300 Pa, the deposition time is 23 min, the flow rate of argon is 6000 sccm, the flow rate of the silane is 2000 sccm, and a flow rate of phosphine is 3000 sccm, and the film thickness is controlled to be 130 nm.

In an operation 5, the method may include depositing a silicon dioxide thin film by using PECVD. A mixed gas of the silane and the nitrous oxide is introduced, the radio frequency power is 10000 watts, the deposition temperature is 420 °C, the process pressure is 200 Pa, the deposition time is 1 min, the flow rate of the silane is 2500 sccm, a flow rate of nitrous oxide is 6000 sccm, and the film thickness is controlled to be 12 nm.

In an operation 6, the method may include performing high-temperature annealing on the substrate after depositing poly (doped amorphous silicon) to activate a phosphorus atom in the poly deposition. Afterwards, RCA wet chemical cleaning is used to remove the doped amorphous silicon at an edge of the substrate and phosphor-silicate glass on the surface of the substrate. Afterwards, an aluminum oxide film (with a thickness of 1 nm to 3 nm) is deposited on a front surface by using atomic layer deposition. Then, silicon nitride coating is performed on the front surface and a rear surface (a front film with a thickness of 70 nm to 85 nm, a rear film with a thickness of 80 nm to 100 nm). Then, screen printing process for electrode printing and sintering (with a sintering temperature of 650 °C to 850 °C) is performed.

The RCA wet cleaning involves an industrial standard wet cleaning process that uses hydrofluoric acid to remove the phosphor-silicate glass layer from the surface of the substrate, and that uses alkali (potassium hydroxide) to remove the doped amorphous silicon layer at the edge of the silicon substrate.

The atomic layer deposition involves depositing thin films on the surface of the substrate layer by layer through a chemical reaction of a gaseous precursor molecule. During the deposition, trimethylaluminum and water vapor are alternately introduced into a reaction chamber to generate the aluminum oxide film. In this embodiment, a thickness of the aluminum oxide film is controlled to be 2.5 nm.

The front film and the rear film are formed by using plasma chemical vapor deposition. Ammonia and the silane are introduced into the reaction chamber to deposit silicon nitride on both the front surface and the rear surface of the substrate. The thickness of the front film is controlled to be 80 nm, and the thickness of the rear film is controlled to be 90 nm.

Printing a front electrode and a rear electrode involves a basic principle. The basic principle is that paste passes through mesh openings in a patterned part, and the paste does not pass through a non-patterned part. Therefore, the front electrode and the rear electrode are prepared.

Sintering: during this process, the silicon atom from the substrate enters a molten metal electrode material at a high temperature, forming an alloy system. After the temperature decreases, the silicon atom of the alloy system recrystallizes, forming an epitaxial layer between the silicon wafer and the metal electrode to establish a good ohmic contact. A sintering temperature is 750 °C.

### Example 2

This example provides a method for making the TOPCon solar cell. Compared with the example 1, the only difference lies in the operation 2.

In the operation 2 of the example 2, the method may include depositing the first oxide layer on the alkaline-polished substrate by using the nitrous oxide ionization. During deposition of the first oxide layer, the flow rate of the nitrous oxide is 10000 sccm, the power is 8000 watts, the deposition time is 15 seconds, and the thickness is controlled to be 0.1 nm. On the basis of the first oxide layer, the second oxide layer is deposited by using PEALD. During deposition of the second oxide layer, the flow rate of the argon carrying the silicon source is 2000 sccm, the flow rate of the nitrous oxide is 2400 sccm, the deposition time is 80 seconds, the power is 9000 watts, and the thickness is controlled to be 0.9 nm.

### Example 3

This example provides a method for making the TOPCon solar cell. Compared with the example 1, the only difference lies in the operation 2.

In the operation 2 of the example 3, the method may include depositing the first oxide layer on the alkaline-polished substrate by using the nitrous oxide ionization. During deposition of the first oxide layer, the flow rate of the nitrous oxide is 10000 sccm, the power is 8000 watts, the deposition time is 15 seconds, and the thickness is controlled to be 0.1 nm. On the basis of the first oxide layer, the second oxide layer is deposited by using PEALD. During deposition of the second oxide layer, the flow rate of the argon carrying the silicon source is 2000 sccm, the flow rate of the nitrous oxide is 2400 sccm, the deposition time is 70 seconds, the power is 9000 watts, and the thickness is controlled to be 0.8 nm.

### Example 4

This example provides a method for making the TOPCon solar cell. Compared with the example 1, the only difference lies in the operation 2.

In the operation 2 of the example 4, the method may include depositing the first oxide layer on the alkaline-polished substrate by using the plasma chemical vapor deposition. During deposition of the first oxide layer, the flow rate of the nitrous oxide is 10000 sccm, the power is 8000 watts, the deposition time is 15 seconds, and the thickness is controlled to be 0.1 nm. On the basis of the first oxide layer, the second oxide layer is deposited by using PEALD. During deposition of the second oxide layer, the total flow rate of the argon carrying the silicon source is 2000 sccm, the flow rate of the nitrous oxide is 2400 sccm, the deposition time is 100 seconds, the power is 9000 watts, and the thickness is controlled to be 1.2 nm.

### Comparative example 1

This comparative example provides a method for making the TOPCon solar cell. Compared with the example 1, the only difference lies in the operation 2.

In the operation 2 of the comparative example 1, the method may include depositing the tunnel oxide layer on the alkaline-polished substrate by using PECVD, the flow rate of the nitrous oxide is 10000 sccm, the power is 8000 watts, the deposition time is 120 seconds, and the thickness is controlled to be 1 nm.

### Comparative example 2

This comparative example provides a method for making the TOPCon solar cell. Compared with the example 1, the only difference lies in the operation 2.

In the operation 2 of the comparative example 2, the method may include depositing the tunnel oxide layer on the alkaline-polished substrate by using PECVD, the flow rate of the nitrous oxide is 10000 sccm, the power is 8000 watts, the deposition time is 150 seconds, and the thickness is controlled to be 1.1 nm.

### Comparative example 3

This comparative example provides a method for making the TOPCon solar cell. Compared with the example 1, the only difference lies in the operation 2.

In the operation 2 of the comparative example 3, the method may include depositing complete tunnel oxide layer on the alkaline-polished substrate by using PEALD, the flow rate of the argon carrying the silicon source is 2000 sccm, the flow rate of the nitrous oxide is 2400 sccm, the deposition time is 90 seconds, the power is 9000 watts, and the thickness is controlled to be 0.9 nm.

### Comparative example 4

This comparative example provides a method for making the TOPCon solar cell. Compared with the example 1, the only difference lies in the operation 2.

In the operation 2 of the comparative example 4, the method may include depositing the first oxide layer on the alkaline-polished substrate by using the plasma chemical vapor deposition. During depositing the first oxide layer, the flow rate of the nitrous oxide is 10000 sccm, the power is 8000 watts, the deposition time is 15 seconds, and the thickness is controlled to be 0.1 nm. On the basis of the first oxide layer, the second oxide layer is deposited by using PEALD. During deposition of the second oxide layer, the total flow rate of the argon carrying the silicon source is 2000 sccm, the flow rate of the nitrous oxide is 2400 sccm, the deposition time is 260 seconds, the power is 9000 watts, and the thickness is controlled to be 2.9 nm.

### Test Example

### 1. Uniformity tests of film layers

The tunnel oxide layers are prepared according to the methods described in each example and each comparative example of the present disclosure. During film thickness measurement, the deposition time for the second oxide layers in the examples 1, 2, 3, and 4, the deposition time for the complete tunnel oxide layer in the comparative example 3, and the deposition time for the second oxide layer in the comparative example 4 extend to 280 seconds, 270 seconds, 260 seconds, 290 seconds, 270 seconds, and 290 seconds, respectively. The deposition time for the complete tunnel oxide layer in each of the comparative examples 1 and 2 extends to 30 min (since the overall thickness of the tunnel oxide layer is too low to be measured by a conventional film thickness measurement instrument, the actual film thickness is set to approximately 4 nm, so that its thickness may be measured by an ellipsometer. As the deposition time increased, the oxide layer became thicker. When the thicker film exhibits good uniformity, it may also reflect the uniformity of the films grown by different methods). Film thickness comparison tests are performed. The differences among the examples and comparative examples are as follows. Point 1 represents the film thickness at a center of the substrate, while points 2 to 5 represent the film thicknesses at four corners of the substrate. Positions of the substrates are selected from outer boat pages and a middle boat page of a graphite boat. Since a large number of wafers may be typically treated in a PECVD furnace tube, A1 to J15 represent samples selected for testing at different positions on the graphite boat. The specific results are shown in table 1.

Regarding the deposition time, the deposition time and the thicknesses of the oxide layers deposited by using PEALD, namely the second oxide layers in the examples 1, 2, 3, and 4, the complete oxide layer in the comparative example 3, and the second oxide layer in the comparative example 4, are linearly related. As the time extends, the thickness increases linearly. In contrast, the deposition time and the thicknesses of the oxide layers deposited by using PECVD, namely the oxide layers in the comparative examples 1 and 2, are non-linearly related. As the time extends, the deposition rate gradually decreases, and a longer time is required to deposit the same thickness.

**Table 1**

| example 1 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 3.68 | 4.27 | 4.12 | 4.15 | 4.20 | 4.08 | 7.22% | | |
| C1 | 3.93 | 4.10 | 4.01 | 4.04 | 4.18 | 4.05 | 3.08% | | |
| E1 | 3.90 | 4.09 | 4.26 | 4.01 | 4.12 | 4.08 | 4.42% | | |
| F1 | 3.91 | 4.46 | 4.10 | 4.07 | 3.90 | 4.09 | 6.85% | | |
| H1 | 3.84 | 4.14 | 4.13 | 4.01 | 3.94 | 4.01 | 3.74% | | |
| J1 | 3.90 | 4.15 | 4.03 | 4.04 | 3.94 | 4.01 | 3.12% | 4.03 | 9.67% |
| A15 | 3.72 | 4.11 | 3.93 | 4.11 | 4.21 | 4.02 | 6.10% | | |
| C15 | 3.76 | 3.85 | 3.96 | 4.08 | 3.97 | 3.92 | 4.08% | | |
| E15 | 3.79 | 3.89 | 4.05 | 4.05 | 3.92 | 3.94 | 3.30% | | |
| F15 | 3.85 | 4.15 | 4.01 | 4.11 | 4.12 | 4.05 | 3.71% | | |
| H15 | 3.85 | 4.04 | 4.07 | 4.03 | 4.17 | 4.03 | 3.97% | | |
| J15 | 3.95 | 4.11 | 4.23 | 4.14 | 4.12 | 4.11 | 3.41% | | |

| example 2 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 3.57 | 4.00 | 3.97 | 4.11 | 3.99 | 3.93 | 6.95% | 3.97 | 11.39% |
| C1 | 3.76 | 3.98 | 3.97 | 3.99 | 3.92 | 3.92 | 2.95% | | |
| E1 | 3.71 | 4.05 | 4.09 | 4.00 | 3.92 | 3.95 | 4.86% | | |
| F1 | 3.69 | 3.97 | 4.10 | 4.08 | 3.90 | 3.95 | 5.18% | | |
| H1 | 3.74 | 4.07 | 4.08 | 4.05 | 3.78 | 3.94 | 4.26% | | |
| J1 | 3.99 | 4.23 | 4.14 | 4.03 | 3.94 | 4.07 | 3.61% | | |
| A15 | 3.73 | 4.11 | 3.96 | 3.77 | 4.26 | 3.97 | 6.62% | | |
| C15 | 3.91 | 3.69 | 4.00 | 3.92 | 3.81 | 3.87 | 3.95% | | |
| E15 | 3.79 | 3.89 | 4.05 | 4.05 | 4.47 | 4.05 | 8.44% | | |
| F15 | 3.69 | 3.85 | 4.08 | 3.95 | 4.18 | 3.95 | 6.22% | | |
| H15 | 3.72 | 3.97 | 4.11 | 3.99 | 3.99 | 3.96 | 4.94% | | |
| J15 | 3.94 | 3.95 | 4.19 | 4.02 | 4.08 | 4.04 | 3.16% | | |

| example 3 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 3.60 | 3.97 | 3.86 | 4.08 | 3.88 | 3.88 | 6.19% | | |
| C1 | 3.53 | 3.87 | 3.94 | 3.88 | 3.89 | 3.82 | 5.30% | | |
| E1 | 3.57 | 4.02 | 3.94 | 3.97 | 3.77 | 3.85 | 5.91% | | |
| F1 | 3.77 | 3.98 | 4.11 | 4.09 | 3.91 | 3.97 | 4.32% | | |
| H1 | 3.63 | 4.12 | 3.93 | 3.90 | 3.64 | 3.84 | 6.36% | | |
| J1 | 4.04 | 4.08 | 4.15 | 4.08 | 3.95 | 4.06 | 2.55% | 3.91 | 12.20% |
| A15 | 3.59 | 4.12 | 3.81 | 3.78 | 4.31 | 3.92 | 9.27% | | |
| C15 | 3.92 | 3.55 | 4.05 | 3.77 | 3.66 | 3.79 | 6.59% | | |
| E15 | 3.79 | 3.90 | 4.06 | 4.06 | 4.49 | 4.06 | 8.58% | | |
| F15 | 3.55 | 3.70 | 4.05 | 3.80 | 4.16 | 3.85 | 7.88% | | |
| H15 | 3.61 | 3.94 | 4.00 | 3.96 | 3.88 | 3.88 | 4.99% | | |
| J15 | 3.91 | 3.84 | 4.16 | 3.91 | 4.05 | 3.97 | 4.08% | | |

| example 4 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 4.41 | 4.29 | 4.09 | 4.37 | 4.23 | 4.28 | 3.70% | 4.17 | 13.60% |
| C1 | 3.69 | 4.37 | 4.17 | 4.02 | 4.27 | 4.10 | 8.27% | | |
| E1 | 3.74 | 4.35 | 4.11 | 4.34 | 3.94 | 4.10 | 7.41% | | |
| F1 | 4.00 | 4.20 | 4.83 | 3.87 | 4.23 | 4.23 | 11.34% | | |
| H1 | 3.75 | 4.50 | 4.32 | 4.07 | 3.81 | 4.09 | 9.14% | | |
| J1 | 4.16 | 4.25 | 4.20 | 4.45 | 4.28 | 4.27 | 3.50% | | |
| A15 | 3.73 | 4.46 | 4.22 | 4.30 | 4.69 | 4.28 | 11.28% | | |
| C15 | 4.25 | 4.03 | 4.26 | 4.28 | 3.84 | 4.13 | 5.33% | | |
| E15 | 4.10 | 4.27 | 4.39 | 4.25 | 4.22 | 4.25 | 3.50% | | |
| F15 | 3.81 | 4.26 | 4.34 | 4.32 | 4.06 | 4.16 | 6.38% | | |
| H15 | 3.83 | 3.99 | 4.15 | 4.25 | 3.98 | 4.04 | 5.22% | | |
| J15 | 4.20 | 4.05 | 4.26 | 4.12 | 4.09 | 4.14 | 2.52% | | |

| comparative example 1 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 3.24 | 4.30 | 4.15 | 4.19 | 4.24 | 4.02 | 13.17% | | |
| C1 | 3.23 | 4.14 | 3.97 | 4.14 | 4.25 | 3.95 | 12.92% | | |
| E1 | 3.28 | 3.88 | 4.00 | 4.11 | 4.00 | 3.85 | 10.77% | | |
| F1 | 3.11 | 3.92 | 4.09 | 4.09 | 3.95 | 3.83 | 12.79% | | |
| H1 | 3.40 | 4.17 | 4.16 | 4.04 | 3.97 | 3.95 | 9.75% | | |
| J1 | 3.19 | 4.19 | 4.05 | 4.14 | 4.15 | 3.94 | 12.68% | 3.94 | 17.91% |
| A15 | 3.29 | 4.08 | 4.11 | 4.06 | 4.20 | 3.95 | 11.52% | | |
| C15 | 3.08 | 4.12 | 4.30 | 4.05 | 4.15 | 3.94 | 15.48% | | |
| E15 | 3.09 | 4.18 | 4.07 | 4.07 | 3.98 | 3.88 | 14.05% | | |
| F15 | 3.27 | 4.49 | 4.13 | 4.10 | 3.93 | 3.98 | 15.31% | | |
| H15 | 3.24 | 4.13 | 4.04 | 4.07 | 4.22 | 3.94 | 12.44% | | |
| J15 | 3.27 | 4.14 | 4.26 | 4.18 | 4.15 | 4.00 | 12.38% | | |

| comparative example 2 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 3.37 | 4.21 | 4.13 | 4.24 | 4.43 | 4.08 | 12.93% | 4.05 | 17.05% |
| C1 | 3.36 | 4.11 | 4.53 | 4.07 | 4.17 | 4.05 | 14.41% | | |
| E1 | 3.32 | 4.02 | 4.40 | 4.24 | 4.29 | 4.06 | 13.30% | | |
| F1 | 3.24 | 4.10 | 4.27 | 4.27 | 4.13 | 4.00 | 12.87% | | |
| H1 | 3.25 | 4.40 | 4.18 | 4.06 | 3.99 | 3.97 | 14.38% | | |
| J1 | 3.30 | 4.21 | 4.23 | 4.36 | 4.33 | 4.09 | 12.96% | | |
| A15 | 3.31 | 4.44 | 4.14 | 4.20 | 4.39 | 4.10 | 13.86% | | |
| C15 | 3.40 | 4.20 | 4.36 | 4.25 | 4.02 | 4.05 | 11.87% | | |
| E15 | 3.35 | 4.26 | 4.50 | 4.25 | 4.25 | 4.12 | 13.98% | | |
| F15 | 3.15 | 4.02 | 4.16 | 4.33 | 4.30 | 3.99 | 14.83% | | |
| H15 | 3.57 | 4.27 | 4.27 | 4.12 | 4.07 | 4.06 | 8.66% | | |
| J15 | 3.39 | 4.20 | 4.10 | 4.21 | 4.28 | 4.03 | 11.06% | | |

| comparative example 3 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 3.33 | 4.04 | 3.88 | 4.07 | 4.17 | 3.90 | 10.79% | | |
| C1 | 2.86 | 3.86 | 4.36 | 3.82 | 4.00 | 3.78 | 19.86% | | |
| E1 | 3.05 | 3.85 | 4.10 | 4.07 | 4.00 | 3.81 | 13.86% | | |
| F1 | 3.16 | 3.97 | 4.15 | 4.15 | 4.00 | 3.89 | 12.69% | | |
| H1 | 3.01 | 4.32 | 3.88 | 3.77 | 3.70 | 3.74 | 17.50% | | |
| J1 | 3.19 | 3.91 | 4.11 | 4.29 | 4.21 | 3.94 | 13.85% | 3.85 | 19.69% |
| A15 | 3.03 | 4.32 | 3.84 | 4.07 | 4.31 | 3.92 | 16.47% | | |
| C15 | 3.26 | 3.90 | 4.28 | 3.96 | 3.73 | 3.83 | 13.38% | | |
| E15 | 3.17 | 4.14 | 4.38 | 4.13 | 4.13 | 3.99 | 15.16% | | |
| F15 | 3.06 | 3.73 | 3.99 | 4.04 | 4.13 | 3.79 | 14.16% | | |
| H15 | 3.22 | 4.10 | 4.02 | 3.95 | 3.82 | 3.82 | 11.55% | | |
| J15 | 3.21 | 3.95 | 3.93 | 3.96 | 4.11 | 3.83 | 11.76% | | |

| comparative example 4 group (nm) | | | | | | | | | |
|---|---|---|---|---|---|---|---|---|---|
| serial number | point 1 | point 2 | point 3 | point 4 | point 5 | average value | within-wafer uniformity (%) | film thickness average | wafer-to-wafer uniformity (%) |
| A1 | 3.91 | 4.12 | 4.21 | 4.20 | 4.25 | 4.14 | 4.11% | 4.21 | 10.10% |
| C1 | 3.96 | 4.20 | 4.70 | 4.33 | 4.40 | 4.32 | 8.57% | | |
| E1 | 3.89 | 4.29 | 4.33 | 4.01 | 4.27 | 4.16 | 5.29% | | |
| F1 | 3.99 | 4.40 | 4.27 | 4.19 | 4.38 | 4.25 | 4.83% | | |
| H1 | 4.01 | 4.22 | 4.34 | 4.25 | 4.38 | 4.24 | 4.36% | | |
| J1 | 3.88 | 4.21 | 4.16 | 4.38 | 4.25 | 4.18 | 5.99% | | |
| A15 | 3.90 | 4.35 | 4.26 | 4.34 | 4.16 | 4.20 | 5.35% | | |
| C15 | 3.95 | 4.29 | 4.39 | 4.22 | 4.36 | 4.24 | 5.19% | | |
| E15 | 3.85 | 4.14 | 4.23 | 4.28 | 4.02 | 3.70 | 5.24% | | |
| F15 | 3.89 | 4.24 | 4.39 | 4.33 | 4.12 | 4.19 | 5.96% | | |
| H15 | 3.99 | 4.34 | 4.29 | 4.35 | 4.34 | 4.26 | 4.22% | | |
| J15 | 4.00 | 4.28 | 4.33 | 4.28 | 4.39 | 4.26 | 4.58% | | |

The film thickness uniformity is calculated by using a formula: (maximum value of film thickness - minimum value of film thickness) / (2 × average value) × 100%. The within-wafer uniformity is calculated based on values of inner film thicknesses of single wafers, while the wafer-to-wafer uniformity is calculated based on the values of film thicknesses of 12 wafers in each group. The smaller the uniformity value, the better the film thickness uniformity.

As shown in table 1, the wafer-to-wafer uniformity of the examples 1, 2, 3, and 4 is significantly superior to that of the comparative examples 1 and 2. This demonstrates that the uniformity of the oxide layers formed by using PECVD and PEALD in the present disclosure is significantly superior to that of the oxide layers formed by using PECVD alone in the related art.

In addition, as mentioned above, when the overall thickness of the tunnel oxide layer is too low, the conventional film thickness measurement instrument (such as the ellipsometer) cannot detect the thickness. Additional data of observing the cross-section of the tunnel oxide layer using a scanning electron microscope (SEM) and calculating the uniformity is provided here. The tunnel oxide layers are prepared according to the methods of the embodiments of the present disclosure. The first oxide layer is prepared by using PECVD, and the second oxide layer is prepared by using PEALD, and a total thickness is controlled to be 1.4 nm (wherein, the thickness of the first oxide layer is controlled to be 0.4 nm, and the thickness of the second oxide layer is controlled to be 1 nm). For the control experiment, the tunnel oxide layer is prepared by using PECVD alone, and the thickness is controlled to be 1.4 nm. The data of the within-wafer uniformity measured by SEM are shown in table 2 below and FIG. 1, wherein the point 1 corresponds to the film thickness at the center of the wafer, and the remaining points correspond to the film thicknesses at four sides and four corners of the wafer. As shown in table 2, the uniformity of the oxide layers formed by using PECVD and PEALD in the present disclosure is significantly superior to that of the oxide layer formed by using PECVD alone in the related art.

**Table 2**

| classification | point 1 (nm) | point 2 (nm) | point 3 (nm) | point 4 (nm) | point 5 (nm) | point 6 (nm) | point 7 (nm) | point 8 (nm) | point 9 (nm) | film thickness average (nm) | within-wafer uniformity (nm) |
|---|---|---|---|---|---|---|---|---|---|---|---|
| PECVD | 1.33 | 1.56 | 1.44 | 1.41 | 1.48 | 1.38 | 1.50 | 1.48 | 1.53 | 1.45 | 7.94% |
| PECVD+ PEALD | 1.41 | 1.51 | 1.45 | 1.42 | 1.48 | 1.43 | 1.49 | 1.50 | 1.52 | 1.46 | 3.76% |

### 2. Electrical performance test

The TOPCon solar cells obtained from the above examples and comparative examples are subjected to electrical performance tests. The specific test operations and parameters are as follows. The electrical performance parameters reflecting the passivation effect of the cell are open-circuit voltage and photoelectric conversion efficiency.

The open-circuit voltage is measured by a voltmeter or a photoelectric conversion efficiency tester. When the solar cell is not connected to a load, the open-circuit voltage of the solar cell is measured by the voltmeter or the photoelectric conversion efficiency tester. In this case, the output current of the solar cell is zero.

Short-circuit current is measured by an ammeter or the photoelectric conversion efficiency tester. When the substrate is short-circuited, the short-circuit current of the solar cell is measured by the ammeter or the photoelectric conversion efficiency tester. In this case, the output voltage of the solar cell is zero.

Conversion efficiency is measured by the photoelectric conversion efficiency tester. The output power and the absorbed optical power of the solar cell under standard illumination conditions is measured by the photoelectric conversion efficiency tester, and the conversion efficiency of the solar cell is calculated accordingly.

Fill factor is measured by the photoelectric conversion efficiency tester. The output current and the output voltage of the solar cell under the standard illumination conditions is measured by the photoelectric conversion efficiency tester, and the fill factor of the solar cell is calculated accordingly.

Series resistance is measured by a resistance meter. That is, the series resistance of the solar cell is measured by the resistance meter. The series resistance may affect the output voltage and the conversion efficiency of the solar cell.

Parallel resistance is measured by the resistance meter. That is, the parallel resistance of the solar cell is measured by the resistance meter. The parallel resistance may affect the output current and the conversion efficiency of the solar cell.

Leakage current is measured by the ammeter or the photoelectric conversion efficiency tester. When the solar cell is not connected to the load, the leakage current of the solar cell is measured by the ammeter or the photoelectric conversion efficiency tester.

**Table 3**

| classification | photoelectric conversion efficiency (%) | fill factor (%) | open-circuit voltage (mV) | short-circuit current (A) | series resistance (Ω) | parallel resistance (Ω) | leakage current (A) |
|---|---|---|---|---|---|---|---|
| example 1 | 24.912 | 83.74 | 707.8 | 13.878 | 0.0007 | 1265 | 0.1242 |
| example 2 | 24.944 | 83.82 | 709.3 | 13.853 | 0.0007 | 1432 | 0.1278 |
| example 3 | 25.010 | 83.68 | 711.3 | 13.874 | 0.0006 | 1244 | 0.1334 |
| example 4 | 24.965 | 83.71 | 708.8 | 13.893 | 0.0007 | 1412 | 0.1253 |
| comparative example 1 | 24.832 | 83.69 | 706.9 | 13.859 | 0.0007 | 1429 | 0.1312 |
| comparative example 2 | 24.806 | 83.76 | 705.3 | 13.865 | 0.0007 | 1358 | 0.1384 |
| comparative example 3 | 24.796 | 83.70 | 704.6 | 13.883 | 0.0007 | 1247 | 0.1254 |
| comparative example 4 | 24.458 | 82.31 | 707.5 | 13.873 | 0.0008 | 2472 | 0.1635 |

**Table 4**

| | thickness (nm) of first oxide layer (PECVD) | thickness (nm) of second oxide layer (PEALD) |
|---|---|---|
| example 1 | 0.1 | 1 |
| example 2 | 0.1 | 0.9 |
| example 3 | 0.1 | 0.8 |
| example 4 | 0.1 | 1.2 |
| comparative example 1 | 1 | 0 |
| comparative example 2 | 1.1 | 0 |
| comparative example 3 | 0 | 0.9 |
| comparative example 4 | 0.1 | 2.9 |

As shown in the data of tables 3 and 4, a sum of the thickness of the first oxide layer and the thickness of the second oxide layer in the example 1 is equal to the thickness of the oxide layer in the comparative example 2; a sum of the thickness of the first oxide layer and the thickness of the second oxide layer in the example 2 is equal to the thickness of the oxide layer in the comparative example 1; and a sum of the thickness of the first oxide layer and the thickness of the second oxide layer in the example 3 is equal to the thickness of the oxide layer in the comparative example 3. In these three groups, the tunnel oxide layers have the same total thickness, but formation methods are different. The open-circuit voltage and the photoelectric conversion efficiency of the examples 1 to 3 are all superior to those of the comparative examples 1 to 3, indicating that the examples 1 to 3 in the present disclosure can achieve good technical effects. In the industrial solar cell field, the improvement of the photoelectric conversion efficiency of the cell can significantly increase the power of a photovoltaic module assembled by multiple cells, and the above-mentioned improvement magnitude represents a notable advancement. This demonstrates that, compared with using PECVD alone or PEALD alone to obtain the oxide layer, even if the obtained tunnel oxide layer has the same thickness, the combination of PECVD and PEALD to obtain the oxide layer in the present disclosure achieves an unexpected technical effect.

Furthermore, as shown in the comparative example 4 above, even if PECVD and PEALD are used in combination, when the thickness range does not fall within the ranges set in the present disclosure, namely "the thickness of the first oxide layer from 0.1 nm to 0.5 nm" and "the thickness of the second oxide layer from 0.3 nm to 2 nm", the electrical performance obtained in the examples 1 to 4 of the present disclosure cannot be achieved.

Based on the above data, in the technical solutions of the embodiments of the present disclosure, the chemical passivation of the surface of the substrate is improved, the damage to the surface of the substrate caused by the plasma bombardment is reduced, and the uniformity of the tunnel oxide layer is improved (tables 1 and 2). Furthermore, without disposing or adding the additional device, the photoelectric conversion efficiency of the TOPCon solar cell is improved (table 3).

In the method for making the TOPCon solar cell in the present disclosure, the conventional method that the tunnel oxide layer is prepared by using PECVD alone is changed. In the present disclosure, PECVD and PEALD are used in combination for preparing the tunnel oxide layer. In the present disclosure, based on the differences between deposition mechanisms of PECVD and PEALD processes, PECVD and PEALD are combined and promote each other. PECVD provides a high-quality c-Si/SiOx interface, and PEALD enables deposition on the high-quality interface. This achieves the atomic-scale thickness precision control required for tunneling in the tunnel oxide layer, as well as the uniformity and the passivation effect required for the thin film, while avoiding the damage to the surface of substrate. In the embodiments of the present disclosure, with the surface Si-based oxidation scheme adopted, the first oxide layer with a thickness of 0.1 nm to 0.5 nm is first grown by using PECVD. Therefore, surface planarization and surface cleaning of the silicon substrate are achieved, and the internal defect recombination is passivated. Then, an atomic layer is epitaxially grown by using PEALD to form the second oxide layer with a thickness of 0.3 nm to 2 nm, thereby achieving the atomic-scale thickness precision control for the tunnel oxide layer. The first oxide layer is formed on the planarized surface of the silicon substrate, and the second oxide layer is formed on the first oxide layer, so that the second oxide layer exhibits excellent uniformity. From the perspective of the final process results, it can be seen that the composite oxide layer has obvious good uniformity, and the chemical passivation of the interface contact is good. This is directly reflected in the electrical performance of the solar cell as an improvement in the open-circuit voltage and an improvement in the photoelectric conversion efficiency. That is, the improvement of the open-circuit voltage and the improvement of the photoelectric conversion efficiency are caused by the improvement of passivation (see data in table 3 of the present disclosure). The normal distribution of conversion efficiency of batch-produced solar cells is more convergent.

That is, in the present disclosure, PECVD and PEALD are combined and promote each other. On the basis of the high-quality interfacial oxide layer, the application requirement for atomic-scale thickness precision control for the tunnel oxide layer is achieved. This resolves the problem that the tunnel oxide layer formed by using PECVD alone has poor tunneling uniformity, while simultaneously retaining the passivation effect of the underlying oxide layer on the surface. This can avoid the electroluminescence (EL) test defect, such as a dark spot, that occurs when the tunnel oxide layer is formed by using the nitrous oxide ionization alone. This also reduces the damage to the surface of the substrate caused by the plasma bombardment, thereby improving the conversion efficiency (passivation effect) of the TOPCon solar cell to a certain extent.

The above embodiments are only examples provided for clear illustration, and not limitations on the implementation methods. For those of ordinary skill in the art, other changes or modifications in different forms can be made based on the above explanation. It is not necessary and impossible to exhaustively list all implementation methods here. The obvious changes or variations arising from this are still within the protection scope of the present disclosure.

## Claims

1. A method for making a TOPCon solar cell, **characterized by** comprising a tunnel oxide layer, wherein a method for making the tunnel oxide layer comprises:
depositing a first oxide layer on a surface of a substrate by using plasma enhanced chemical vapor deposition, wherein a thickness of the first oxide layer ranges from 0.1 nm to 0.5 nm; and
depositing a second oxide layer by using plasma enhanced atomic layer deposition.

2. The method for making the TOPCon solar cell as claimed in claim 1, wherein the thickness of the first oxide layer ranges from 0.1 nm to 0.2 nm.

3. The method for making the TOPCon solar cell as claimed in claim 1, wherein a thickness of the second oxide layer ranges from 0.3 nm to 2 nm.

4. The method for making the TOPCon solar cell as claimed in any one of claims 1 to 3, comprising:
S1, texturing, performing diffusion on, and alkaline polishing the substrate;
S2, depositing the tunnel oxide layer;
S3, depositing an intrinsic amorphous silicon layer;
S4, depositing a doped amorphous silicon layer;
S5, depositing a silicon dioxide layer; and
S6, annealing, wet cleaning, depositing an atomic layer, coating, printing a front electrode and a rear electrode, and sintering.

5. The method for making the TOPCon solar cell as claimed in claim 4, wherein the intrinsic amorphous silicon layer is deposited by using the plasma enhanced chemical vapor deposition in S3; and/or
wherein a thickness of the intrinsic amorphous silicon layer ranges from 10 nm to 20 nm.

6. The method for making the TOPCon solar cell as claimed in claim 4, wherein the doped amorphous silicon layer is deposited by using the plasma enhanced chemical vapor deposition in S4; and/or
wherein a thickness of the doped amorphous silicon layer ranges from 20 nm to 130 nm; and/or
wherein the doped amorphous silicon layer comprises a phosphorus doped amorphous silicon layer.

7. The method for making the TOPCon solar cell as claimed in claim 4, wherein the silicon dioxide layer is deposited by using the plasma enhanced chemical vapor deposition in S5; and/or
wherein a thickness of the silicon dioxide layer ranges from 10 nm to 15 nm.

8. The method for making the TOPCon solar cell as claimed in claim 4, wherein in S 1, the texturing the substrate comprises texturing the substrate through alkali corrosion to form a textured surface; and/or
the performing diffusion on the substrate comprises doping a boron element on a front surface of the substrate; and/or
the alkaline polishing the substrate comprises alkaline polishing a rear surface of the substrate to form a polished surface.

9. The method for making the TOPCon solar cell as claimed in claim 4, wherein in S6, the wet cleaning comprises removing a doped amorphous silicon layer at an edge of the substrate and removing a phosphor-silicate glass layer on a rear surface of the substrate; and/or
the depositing the atomic layer comprises depositing an aluminum oxide passivation layer on a front surface of the substrate; and/or
the coating comprises depositing a silicon nitride anti-reflection layer on each of the front surface and the rear surface of the substrate; and/or
a sintering temperature ranges from 750 °C to 800 °C, and sintering time ranges from 1 min to 2 min.

10. A TOPCon solar cell, prepared by the method for making the TOPCon solar cell as claimed in any one of claims 1 to 9.
